# EUROPEAN PATENT APPLICATION

(11) **EP 4 686 352 A2**
(43) Date of publication of application: **28.01.2026**
(21) Application number: 25222665.9
(22) Date of filing: 22.10.2021
(51) Int. Cl.: H10H 29/85

(54) **LIGHT-EMITTING DEVICE, LIGHT-EMITTING SUBSTRATE, AND METHOD FOR MANUFACTURING LIGHT-EMITTING DEVICE**

(30) Priority: 31.05.2021 CN 202110603573
(62) Divisional of application: 21943828.0
(71) Applicant: BOE Technology Group Co., Ltd., Beijing 100015 (CN)
(72) Inventor: QIN, Bin, Beijing, 100176 (CN); PENG, Kuanjun, Beijing, 100176 (CN); LIU, Weixing, Beijing, 100176 (CN); ZHANG, Fangzhen, Beijing, 100176 (CN); DONG, Xue, Beijing, 100176 (CN); PENG, Jintao, Beijing, 100176 (CN); TENG, Wanpeng, Beijing, 100176 (CN); LI, Xiaolong, Beijing, 100176 (CN); SUN, Shuang, Beijing, 100176 (CN); CHEN, Wanzhi, Beijing, 100176 (CN); YUAN, Guangcai, Beijing, 100176 (CN); JIA, Qian, Beijing, 100176 (CN)
(74) Representative: Cohausz & Florack

(57) **Abstract**

A light-emitting device, a light-emitting substrate, and a method for manufacturing the light-emitting device. The light-emitting device includes at least one light-emitting structure. The light-emitting structure includes: a first semiconductor layer (21); a light-emitting layer (3); a second semiconductor layer (22), doping ions of the second semiconductor layer (22) and a first semiconductor layer (21) being oppositely charged; a barrier structure (4) provided with an opening for exposing the second semiconductor layer (22), the orthographic projection of the opening being located in the orthographic projection of the light-emitting layer (3) on the base substrate (1), and the area of the opening being smaller than that of the light-emitting layer (3); and a landing electrode (6) located on the side of the barrier structure (4) facing away from the second semiconductor layer (22), the landing electrode (6) being in contact with the second semiconductor layer (22) by the opening.

## Description

### Field

The present disclosure relates to the technical field of semiconductors, in particular to a light-emitting device, a light-emitting substrate, and a method for manufacturing the light-emitting device.

### Background

Light-emitting diode (LED) display refers to a technology that traditional LEDs are arrayed and miniaturized, and then subjected to addressing and mass transfer to a circuit substrate to form ultra-small pitch LEDs, and the length of millimeter-level LEDs is further miniaturized to micron-level, so as to achieve ultra-high pixels and ultra-high resolution, which can adapt to screens of various sizes in theory. Generally, an LED growth backplate includes sapphire, a GaN layer on a Si chip, SiC, and so on. Compared with organic light-emitting display and liquid crystal display, the LED display has the advantages of higher luminous efficiency, better display effects, and lower power, and thus becomes a research hotspot in the display industry.

### Summary

The present disclosure provides a light-emitting device, a light-emitting substrate. The light-emitting device as defined in any one of claims 1-12.

An embodiment of the present disclosure also provides a light-emitting substrate, including a driving backplane and the light-emitting devices provided by any one of claims 1-12 disposed on one side of the driving backplane.

### Brief Description of the Drawings

FIG. 1 is a first schematic sectional view of a light-emitting device according to an embodiment of the present disclosure;
FIG. 2 is a second schematic sectional view of the light-emitting device according to the embodiment of the present disclosure;
FIG. 3 is a third schematic sectional view of the light-emitting device according to the embodiment of the present disclosure;
FIG. 4 is a schematic top view of a connection pad layer according to an embodiment of the present disclosure;
FIG. 5 is a schematic sectional view of a light-emitting substrate according to an embodiment of the present disclosure;
FIG. 6 is a schematic top view of a driving backplane according to an embodiment of the present disclosure;
FIG. 7 is a schematic flow chart of manufacturing of a light-emitting device according to an embodiment of the present disclosure;
FIG. 8A is a schematic sectional view after forming a second semiconductor layer 22;
FIG. 8B is a top view of a single film layer of a light-emitting layer 3;
FIG. 8C is a top view of a single film layer of a second semiconductor layer 22;
FIG. 9A is a schematic sectional view after forming a third semiconductor layer 41;
FIG. 9B is a top view of a single film layer of the third semiconductor layer 41;
FIG. 10A is a schematic sectional view after forming a landing electrode 6;
FIG. 10B is a top view of a single film layer of a passivation layer 42;
FIG. 10C is a top view of a single film layer of a bridge electrode 5;
FIG. 10D is a top view of a single film layer of the landing electrode 6;
FIG. 11A is a schematic sectional view after forming an encapsulation layer 73;
FIG. 11B is a top view of a single film layer of a reflective layer 71;
FIG. 11C is a top view of a single film layer of a heat dissipation layer 72;
FIG. 11D is a top view of a single film layer of the encapsulation layer 73;
FIG. 12A is a schematic sectional view of FIG. 12C along a dashed line E1F1;
FIG. 12B is a top view of a single film layer of a connection pad layer 8;
FIG. 12C is a first top view of the overall light-emitting device;
FIG. 13A is a schematic sectional view of FIG. 13B along a dashed line E2F2;
FIG. 13B is a second top view of the overall light-emitting device;
FIG. 14A is a schematic sectional view of FIG. 14B along a dashed line E3F3;
FIG. 14B is a third top view of the overall light-emitting device;
FIG. 15A is a schematic sectional view of FIG. 15B along a dashed line E4F4; and
FIG. 15B is a fourth top view of the overall light-emitting device.

### Detailed Description of the Embodiments

In order to make the objectives, technical solutions, and advantages of the embodiments of the present disclosure clearer, the technical solutions of the embodiments of the present disclosure will be described clearly and completely with reference to accompanying drawings of the embodiments of the present disclosure. Apparently, the described embodiments are some, not all, of the embodiments of the present disclosure. Based on the described embodiments of the present disclosure, all other embodiments obtained those of ordinarily skill in the art without creative work fall within the protection scope of the present disclosure.

Unless otherwise defined, technical or scientific terms used in the present disclosure shall have the ordinary meaning as understood by those of ordinary skill in the art to which the present disclosure belongs. "First", "second" and similar words used in the present disclosure do not represent any order, quantity, or importance, but are merely used to distinguish different components. "Include" or "comprise" and other similar words mean that an element or an item preceding the word cover elements or items and their equivalents listed after the word without excluding other elements or items. "Connection" or "connected" and other similar words may include electrical connection, direct or indirect, instead of being limited to physical or mechanical connection. "Upper", "lower", "left", "right", etc. are only used to indicate a relative position relationship, and the relative position relationship may also change accordingly when an absolute position of a described object changes.

To keep the following description of the embodiments of the present disclosure clear and concise, the present disclosure omits detailed descriptions of well-known functions and well-known components.

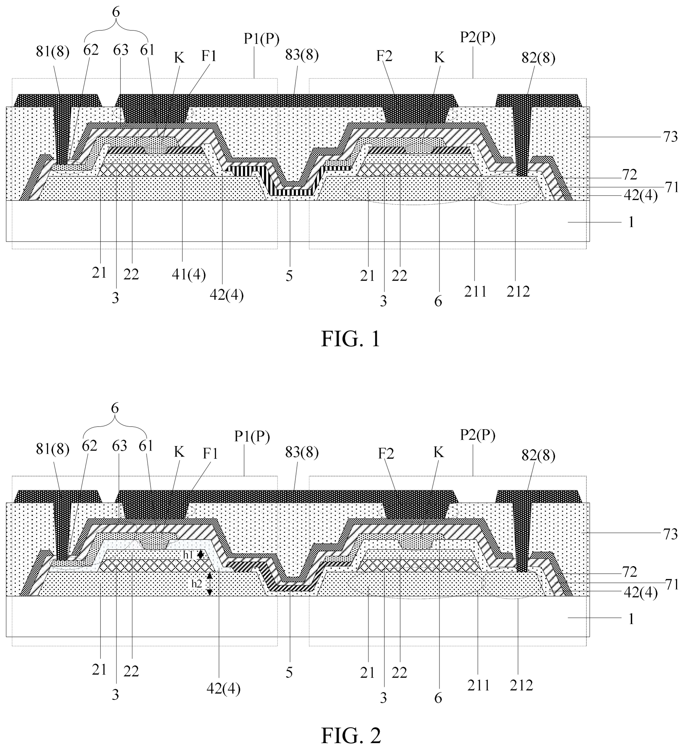

It is found through a test of the photoelectric properties of LEDs that the luminous efficiency of the LEDs and the density of current passing through a light-emitting region of the LEDs have a relationship as shown in FIG. 1. The luminous efficiency of the LEDs increases with the increase of the current density, and shows a trend of luminous efficiency saturation after reaching a certain degree. Further, compared with a gray scale required by a mainstream display screen at this stage, it is found that application of the luminous efficiency of the LEDs by a LED display panel is far from reaching a high-efficiency light-emitting region of the LEDs at present. As shown in FIG. 1, if a light-emitting region of L255 is reduced to 25%, the luminous efficiency of the LEDs is increased by about 20%, and accordingly, the power consumption of backplanes of the LEDs can be reduced on the basis of maintaining the excellent display quality. Therefore, reducing a light-emitting area of the LEDs and increasing the current density in a certain manner to improve the luminous efficiency become a new idea of reducing power consumption of the LED display panel.

In view of this, referring to Figs. 1, 2, and 3, an embodiment of the present disclosure provides a light-emitting device, including: a base substrate 1, and at least one light-emitting structure P located on one side of the base substrate 1; wherein the light-emitting structure P includes:
a first semiconductor layer 21;
a light-emitting layer 3 located on the side, facing away from the base substrate 1, of the first semiconductor layer 21; wherein in particular, the light-emitting layer may be a multiple quantum well (MQW) layer; and the base substrate 1 is configured to grow a semiconductor layer and a light-emitting layer, for example, the base substrate 1 may be a sapphire substrate;
a second semiconductor layer 22 located on the side, facing away from the first semiconductor layer 21, of the light-emitting layer 3, wherein doping ions of the second semiconductor layer 22 and the first semiconductor layer 21 are oppositely charged; specifically, for example, the first semiconductor layer 21 can be an n-doped semiconductor layer, and the second semiconductor layer 22 can be a p-doped semiconductor layer; specifically, a material of the first semiconductor layer 21 may be n-doped GaN, and a material of the second semiconductor layer 22 may be p-doped GaN;
a barrier structure 4 located on the side, facing away from the light-emitting layer 3, of the second semiconductor layer 22, wherein the barrier structure 4 is provided with an opening K for exposing the second semiconductor layer 22, an orthographic projection of the opening K on the base substrate 1 is located in an orthographic projection of the light-emitting layer 3 on the base substrate 1, and an area of the opening K is smaller than that of the light-emitting layer 3; and
a landing electrode 6 located on the side, facing away from the second semiconductor layer 22, of the barrier structure 4, wherein the landing electrode 6 is in contact with the second semiconductor layer 22 through the opening K.

In some embodiments of the present disclosure, the side, facing away from the light-emitting layer 3, of the second semiconductor layer 22 is provided with the barrier structure 4, the barrier structure 4 is provided with the opening K for exposing the second semiconductor layer 22, the orthographic projection of the opening K on the base substrate 1 is located in the orthographic projection of the light-emitting layer 3 on the base substrate 1, and the area of the opening K is smaller than that of the light-emitting layer 3, the landing electrode 6 is in contact with the second semiconductor layer 22 through the opening K, the opening K for exposing the second semiconductor layer 22 of the barrier structure 4 forms an effective light-emitting region, an area of the effective light-emitting region is smaller than that of the original light-emitting layer 3, so that a light-emitting region of the light-emitting device is reduced, the luminous efficiency of the light-emitting device can be improved under the condition that the applied gray scale voltage is the same, and the power consumption of the light-emitting device is reduced on the basis of maintaining the excellent display quality.

In a specific implementation, the barrier structure 4 can be formed in different ways, and specific examples are given below.

For example, in one possible embodiment, referring to in FIG. 1, an orthographic projection of the second semiconductor layer 22 on the base substrate 1 and the orthographic projection of the light-emitting layer 3 on the base substrate 1 substantially coincide with each other; the barrier structure 4 includes a third semiconductor layer 41, and a passivation layer 42 located on the side, facing away from the second semiconductor layer 22, of the third semiconductor layer 41, wherein doping ions of the third semiconductor layer 41 and the second semiconductor layer 22 are oppositely charged; in particular, for example, when the second semiconductor layer 22 is an n-doped semiconductor layer, the third semiconductor layer 41 specifically may be a p-doped semiconductor layer, and further, when a material of the second semiconductor layer 22 may be n-doped GaN, a material of the third semiconductor layer 41 specifically may be p-doped GaN; the third semiconductor layer 41 is provided with a first sub-opening K1 for exposing a part of the second semiconductor layer 22, the passivation layer 42 is provided with a second sub-opening K2 for exposing the third semiconductor layer 41 and the first sub-opening K1; and the landing electrode 6 is in contact with the second semiconductor layer 22 through the first sub opening K1 of the third semiconductor layer 41. In the embodiment of the present disclosure, by forming the third semiconductor layer 41 of which doping ions, and doping ions of the second semiconductor layer 22 are oppositely charged, the third semiconductor layer 41 and the second semiconductor layer 22 form a reverse PN junction when the light-emitting structure P is operated, thereby blocking the flow of carriers (for example, electrons), forming an effective light-emitting region in a region where the first sub-opening K1 is located, and lowering the light-emitting region of the light-emitting device.

In some embodiments, the third semiconductor layer 41 may be an electron blocking layer.

For another example, in one possible embodiment, referring to FIG. 2, the orthographic projection of the second semiconductor layer 22 on the base substrate 1 and the orthographic projection of the light-emitting layer 3 on the base substrate 1 substantially coincide with each other; the barrier structure 4 includes a passivation layer 42; the passivation layer 42 is provided with a third sub-opening K3 for exposing a part of the second semiconductor layer 22; and the landing electrode 6 is in contact with the second semiconductor layer 22 through the third sub opening K3 of the passivation layer 42. In the embodiment of the present disclosure, by reducing the size of the third sub-opening K3 of the passivation layer 42, the control of the effective light-emitting region is then achieved, and thus, a way of reducing the light-emitting region is simple and easy to implement.

In particular, a thickness of the second semiconductor layer 22 is 2-4% of a thickness of the first semiconductor layer. In some embodiments of the present disclosure, by reducing the size of the third sub-opening K3 of the passivation layer 42 to reduce the effective light-emitting region, the thickness of the second semiconductor layer 22 is 2-4% of the thickness of the first semiconductor layer, excessive lateral diffusion of current in the second semiconductor layer 22 can be avoided, and the current can enter the light-emitting layer 3 as soon as possible, so as to have a higher luminous efficiency.

For another example, in one possible embodiment, the orthographic projection of the second semiconductor layer 22 on the base substrate 1 is located in the orthographic projection of the light-emitting layer 3 on the base substrate 1, and an area of the orthographic projection of the second semiconductor layer 22 on the base substrate 1 is smaller than that of the orthographic projection of the light-emitting layer 3 on the base substrate 1; the barrier structure 4 includes a passivation layer 42; the passivation layer 42 is provided with a fourth sub-opening K4 for exposing at least part of the second semiconductor layer 22; and the landing electrode 6 is in contact with the second semiconductor layer 22 through the fourth sub-opening K4 of the passivation layer 42. In the embodiment of the present disclosure, by reducing the area of the second semiconductor layer 22, the control of the effective light-emitting region is then achieved, and thus, a way of reducing the light-emitting region is simple and easy to implement.

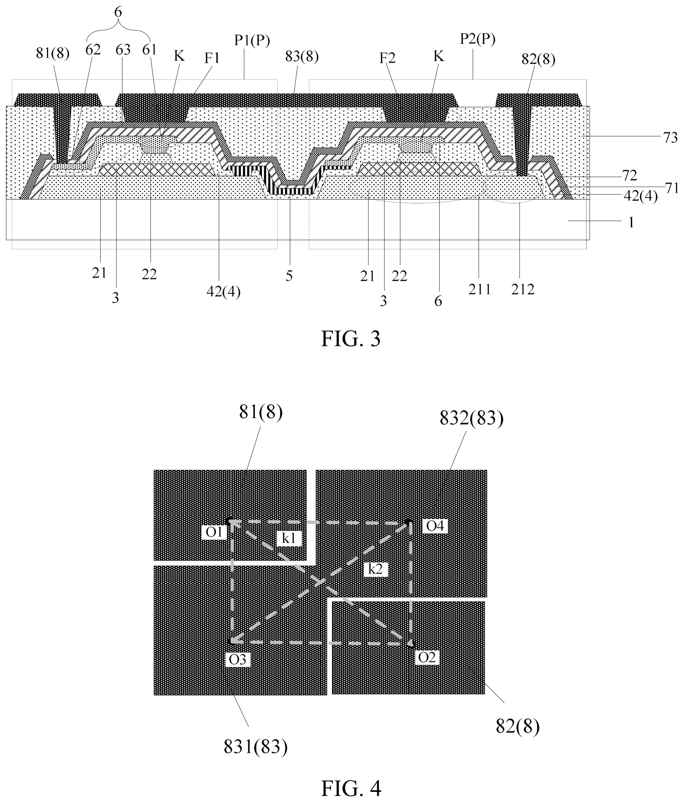

In particular, the reduction of the effective light-emitting region may be achieved only by reducing the area of the second semiconductor layer 22, e.g., referring to FIG. 3, an orthographic projection of the fourth sub-opening K4 on the base substrate 1 and the orthographic projection of the second semiconductor layer 22 on the base substrate 1 substantially coincide with each other. In particular, it is also possible to reduce the size of the fourth sub-opening K4 of the passivation layer 42 while reducing the area of the second semiconductor layer 22. For example, making the orthographic projection of the fourth sub-opening K4 on the base substrate 1 to be smaller than the orthographic projection of the second semiconductor layer 22 on the base substrate 1 can further reduce the effective light-emitting region.

In particular, referring to FIG. 3, an area of the second semiconductor layer 22 is one fifth to four fifths of an area of the light-emitting layer 3. In some embodiments of the present disclosure, since the area of the second semiconductor layer 22 is one fifth to four fifths of the area of the light-emitting layer 3, the reduction of the effective light-emitting region can be achieved by reducing the area of the second semiconductor layer 22, while avoiding a situation that the effective light-emitting region is too small and the light output is too small, affecting normal use of the light-emitting device.

In one possible embodiment, referring to Figs. 1, 2, and 3, the light-emitting device includes at least two light-emitting structures P connected in series with each other; the light-emitting device further includes an encapsulation layer 73 located on the side, facing away from the barrier structure 4, of the landing electrode 6, and the at least two light-emitting structures P connected in series with each other are integrally encapsulated by the encapsulation layer 73. In the embodiment of the present disclosure, the light-emitting device includes at least two light-emitting structures P connected in series with each other, in an active LED driving circuit, in a current path of VDD→VSS, the light-emitting device is equivalent to connecting two light-emitting structures in series, the light-emitting device has a higher crossover voltage, the voltage of a transistor in the driving circuit is reduced, and a high-voltage light-emitting device is formed, which can greatly reduce the cost of the light-emitting device, reduce the current of the circuit and reduce the power consumption.

In one possible embodiment, referring to Figs. 1, 2, and 3, the light-emitting device includes a first light-emitting structure P1 and a second light-emitting structure P2 which are connected in series with each other; the light-emitting device further includes a bridge electrode 5 located between the barrier structure 4 and the landing electrode 6; the first semiconductor layer 21 of the first light-emitting structure P1 and the landing electrode 6 of the second light-emitting structure P2 are electrically connected by the bridge electrode 5, thereby realizing series connection of different light-emitting structures P.

In particular, referring to Figs. 1, 2, and 3, the barrier structure 4 at least includes a passivation layer 42; one end of the bridge electrode 5 is electrically connected with the first semiconductor layer 21 of the first light-emitting structure P1 by a via hole penetrating the passivation layer 42, and the other end of the bridge electrode 5 is in direct contact and electrically connected with the landing electrode 6 of the second light-emitting structure P2.

In one possible embodiment, referring to Figs. 1, 2, and 3, the light-emitting device further includes a connection pad layer 8 located on the side, facing away from the second semiconductor layer 22, of the encapsulation layer 73, wherein the connection pad layer 8 includes a first connection electrode pad 81 electrically connected with the landing electrode 6 of the first light-emitting structure P1, and a second connection electrode pad 82 electrically connected with the first semiconductor layer 21 of the second light-emitting structure P2, thus leading out different electrode terminals of the two light-emitting structures P connected in series with each other.

In one possible embodiment, referring to Figs. 1, 2, and 3, the landing electrode 6 of the first light-emitting structure P1 includes a first contact portion 61 in contact with the second semiconductor layer 22, a first landing portion 62, and a first connection portion 63 connecting the first contact portion 61 and the first landing portion 62; wherein an orthographic projection of the first landing portion 62 on the base substrate 1 does not overlap with the orthographic projection of the light-emitting layer 3 on the base substrate 1; the first connection electrode pad 81 is electrically connected with the first landing portion 62 through a via hole, thereby moving the lead-out position of the landing electrode 6 in the first light-emitting structure P1 out of the effective light-emitting region, thereby improving the luminous efficiency; the first semiconductor layer 21 of the second light-emitting structure P2 is provided with an overlapping portion 211 which overlaps with the light-emitting layer 3, and an extension portion 212 extending from the overlapping portion 211, and the second connection electrode pad 82 is electrically connected with the extension portion 212 through a via hole, thereby moving the lead-out position of the first semiconductor layer 21 in the second light-emitting structure P2 out of the effective light-emitting region, thereby improving the luminous efficiency. Compared with a situation that when the lead-out position of the landing electrode 6 in the first light-emitting structure P1 and the lead-out position of the first semiconductor layer 21 in the second light-emitting structure P2 are still in the effective light-emitting region, the proportion of via holes increases, and when the effective light-emitting region of the light-emitting structure P is reduced, the luminous efficiency of the light-emitting structure P decreases, in the embodiment of the present disclosure, by moving the lead-out positions out of the effective light-emitting region, the problem that the luminous efficiency may be reduced after the effective light-emitting region of the light-emitting structure P is reduced can be improved.

In one possible embodiment, the light-emitting device further includes a heat dissipation layer 72 located between the encapsulation layer 73 and the landing electrode 6; an orthographic projection of the heat dissipation layer 72 on the base substrate 1 at least covers an orthographic projection of the opening K of the first light-emitting structure P1 on the base substrate 1, and an orthographic projection of the opening K of the second light-emitting structure P2 on the base substrate 1. In some embodiments of the present disclosure, the light-emitting device further includes the heat dissipation layer 72 located between the encapsulation layer 73 and the landing electrode 6, which can effectively dissipate heat generated by the light-emitting structure P.

In one possible embodiment, the connection pad layer 8 further includes a heat dissipation pad 83 which is in a conducting relationship with the heat dissipation layer 72, and an orthographic projection of the heat dissipation pad 83 on the base substrate 1 at least covers the orthographic projection of the opening K1 of the first light-emitting structure P1 on the base substrate 1, and covers the orthographic projection of the opening of the second light-emitting structure P2 on the base substrate 1. After reducing the effective light-emitting region of the light-emitting structure P, although the luminous efficiency of the light-emitting structure P is improved, heat generation points are more concentrated, and heat is more easily accumulated to the light-emitting region, in the embodiment of the present disclosure, the connection pad layer 8 further includes the heat dissipation pad 83 which is in a conducting relationship with the heat dissipation layer 72, which can quickly and efficiently dissipate heat generated by the light-emitting structure P after the effective light-emitting region is reduced, reduce the junction temperature of the light-emitting structure P, and avoid the reduction of luminous efficiency or burning of the light-emitting structure P.

In one possible embodiment, the encapsulation layer 73 is provided with a first encapsulation opening F1 and a second encapsulation opening F2; wherein an orthographic projection of the first encapsulation opening F1 on the base substrate 1 covers the orthographic projection of the opening K of the first light-emitting structure P1 on the base substrate 1, and an orthographic projection of the second encapsulation opening F2 on the base substrate 1 covers the orthographic projection of the opening K of the second light-emitting structure P2 on the base substrate 1; and the heat dissipation pad 83 is in contact with the heat dissipation layer 72 through the first encapsulation opening F1 and the second encapsulation opening F2. In the embodiment of the present disclosure, by providing the first encapsulation opening F1 and the second encapsulation opening F2 at the openings K to make the heat dissipation pad 83 and the heat dissipation layer 72 conductive at the effective light-emitting region, the length of a heat dissipation channel can be shortened, so that the heat generated by the light-emitting structure P can be quickly and effectively dissipated.

In one possible embodiment, referring to FIG. 4, the heat dissipation pad 83 includes a first heat dissipation pad 831 covering the opening K of the first light-emitting structure P1, and a second heat dissipation pad 832 covering the opening K of the second light-emitting structure P2, wherein the first heat dissipation pad 831 and the second heat dissipation pad 832 are integrally connected; a center O1 of the first connection electrode pad 81, a center O2 of the second connection electrode pad 82, a center O3 of the first heat dissipation pad 831, and a center O4 of the second heat dissipation pad 832 enclose a rectangle; and the center O1 of the first connection electrode pad 81 and the center O2 of the second connection electrode pad 82 are respectively located at two vertices on one diagonal line k1 of the rectangle, and the center O3 of the first heat dissipation pad 831 and the center O4 of the second heat dissipation pad 832 are respectively located at two vertices on the other diagonal line k2 of the rectangle.

In one possible embodiment, referring to Figs. 1, 2 and 3, a reflective layer 71 is also arranged between the heat dissipation layer 8 and the landing electrode 6. About 50% of light emitted from the light-emitting layer 3 faces away from the side of the base substrate 1, so the reflective layer 71, which may in particular be a distributed Bragg reflector (DBR), is required to reflect the light facing away from the base substrate 1 back to the base substrate 1 to improve the light emission of the light-emitting structure P. In particular, the reflective layer 71 may adopt a 1/4 wavelength reflector of desired light composed of superimposed SiO2 and TiO2.

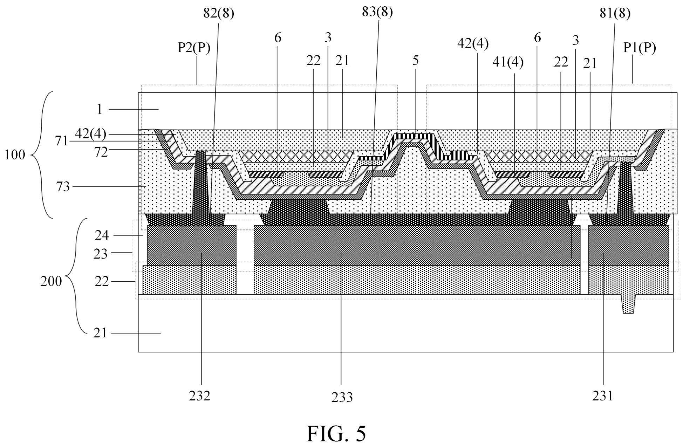

Based on the same inventive concept, referring to FIG. 5, an embodiment of the present disclosure also provides a light-emitting substrate, including a driving backplane 200 and the light-emitting devices provided by embodiments of the present disclosure disposed on one side of the driving backplane 200.

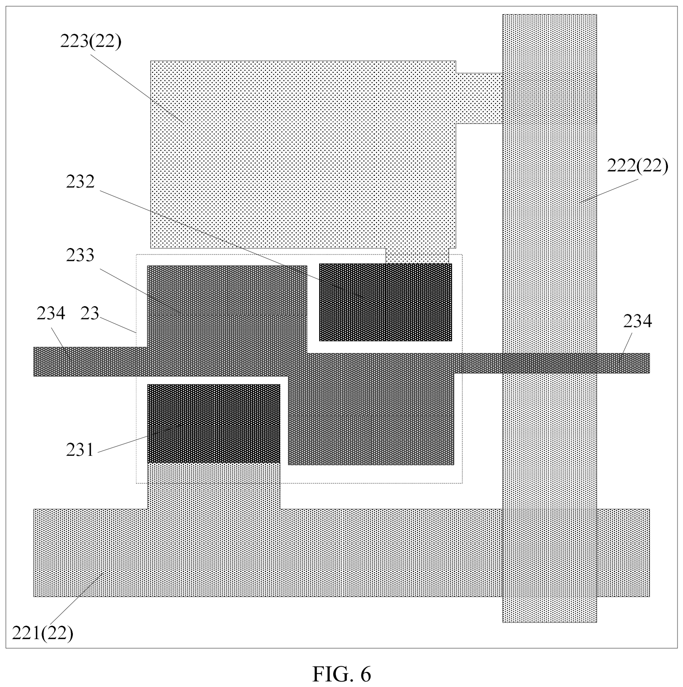

In one possible embodiment, referring to Figs. 5 and 6, the driving backplane 200 includes driving structures 23 in one-to-one correspondence with the light-emitting devices, wherein each driving structure 23 includes a first electrode 231, a second electrode 232, and a heat dissipation electrode 233; wherein each first electrode 231 is in bound connection with the corresponding first connection electrode pad 81, each second electrode 232 is in bound connection with the corresponding second connection electrode pad 82, and the heat dissipation electrode 233 is in bound connection with the corresponding heat dissipation pad 83.

In one possible embodiment, referring to FIG. 6, the driving backplate 200 further includes heat dissipation connection electrodes 234, wherein the heat dissipation electrodes 233 of the different driving structures 23 are electrically connected to each other through the heat dissipation connection electrodes 234.

In one possible embodiment, the driving backplate 200 may further includes a driving base substrate 21, the driving structures 23 are located on one side of the driving base substrate 21, a driving layer 22 is also arranged between the driving base substrate 21 and the driving structures 23, and the driving layer 22 may in particular be a composite layer including a plurality of film layers. The driving layer 22 may include a first power supply line 221, a second power supply line 222, and a drive circuit 223. The first power supply line 221 may in particular be a VDD power supply line, and the second power supply line 222 may in particular be a VSS power supply line. The drive circuit 223 may specifically include a thin film transistor and a capacitor.

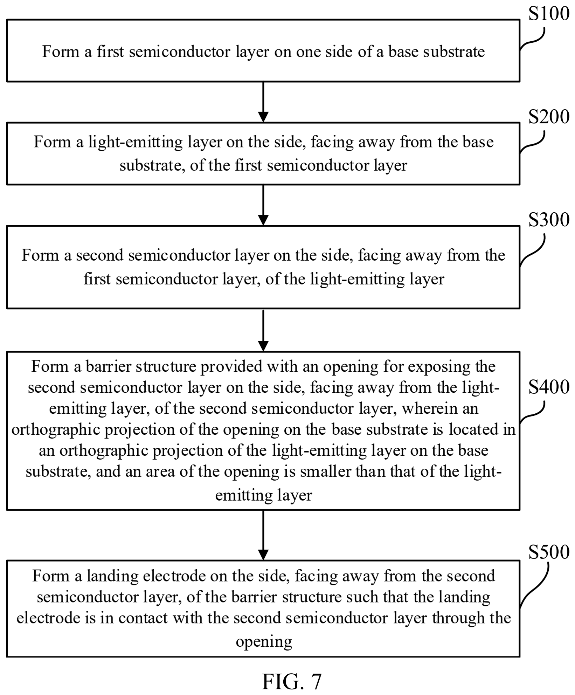

Based on the same inventive concept, referring to FIG. 7, an embodiment of the present disclosure also provides a method for manufacturing a light-emitting device, including:
step S100, forming a first semiconductor layer on one side of a base substrate;
step S200, forming a light-emitting layer on the side, facing away from the base substrate, of the first semiconductor layer;
step S300, forming a second semiconductor layer on the side, facing away from the first semiconductor layer, of the light-emitting layer;
step S400, forming a barrier structure provided with an opening for exposing the second semiconductor layer on the side, facing away from the light-emitting layer, of the second semiconductor layer, wherein an orthographic projection of the opening on the base substrate is in an orthographic projection of the light-emitting layer on the base substrate, and an area of the opening is smaller than that of the light-emitting layer; and
step S500, forming a landing electrode on the side, facing away from the second semiconductor layer, of the barrier structure such that the landing electrode is in contact with the second semiconductor layer through the opening.

In one possible embodiment, an effective light-emitting region can be reduced by forming a third semiconductor layer 41, and in particular the step S400, i.e., forming the barrier structure provided with the opening for exposing the second semiconductor layer on the side, facing away from the light-emitting layer, of the second semiconductor layer includes:
step S411, forming a third semiconductor layer on the side, facing away from the light-emitting layer, of the second semiconductor layer, wherein doping ions of the third semiconductor layer and the second semiconductor layer are oppositely charged;
step S412, patterning the third semiconductor layer to form a first sub-opening for exposing a part of the second semiconductor layer; and
step S413, forming a passivation layer provided with a second sub-opening on the side, facing away from the second semiconductor layer, of the third semiconductor layer, wherein the second sub-opening exposes the third semiconductor layer and the first sub-opening.

In one possible embodiment, the effective light-emitting region can be reduced by adjusting the size of the opening of the passivation layer, and in particular the step S400, i.e., forming the barrier structure provided with the opening for exposing the second semiconductor layer on the side, facing away from the light-emitting layer, of the second semiconductor layer includes:
step S421, forming a passivation layer on the side, facing away from the light-emitting layer, of the second semiconductor layer; and
step S422, patterning the passivation layer to form a third sub-opening for exposing a part of the second semiconductor layer such that the landing electrode is in contact with the second semiconductor layer through the third sub-opening.

In one possible embodiment, the effective light-emitting region can be reduced by adjusting an area of the second semiconductor layer, and in particular the step S300, i.e., forming the second semiconductor layer on the side, facing away from the first semiconductor layer, of the light-emitting layer includes: forming a second semiconductor layer of which an orthographic projection on the base substrate is located in the orthographic projection of the light-emitting layer on the base substrate on the side, facing away from the first semiconductor layer, of the light-emitting layer, and an area of the orthographic projection of the second semiconductor layer on the base substrate is smaller than that of the orthographic projection of the light-emitting layer on the base substrate.

Correspondingly, the step S400 of forming the barrier structure provided with the opening for exposing the second semiconductor layer on the side, facing away from the light-emitting layer, of the second semiconductor layer includes:
step S431, forming a passivation layer on the side, facing away from the light-emitting layer, of the second semiconductor layer; and
step S432, patterning the passivation layer to form a fourth sub-opening for exposing the second semiconductor layer such that the landing electrode is in contact with the second semiconductor layer through the fourth sub-opening, wherein an orthographic projection of the fourth sub-opening on the base substrate and the orthographic projection of the second semiconductor layer on the base substrate substantially coincide with each other.

In order to more clearly understand the method for manufacturing the light-emitting device provided by the embodiment of the present disclosure, further description is made as follows by specific embodiments.

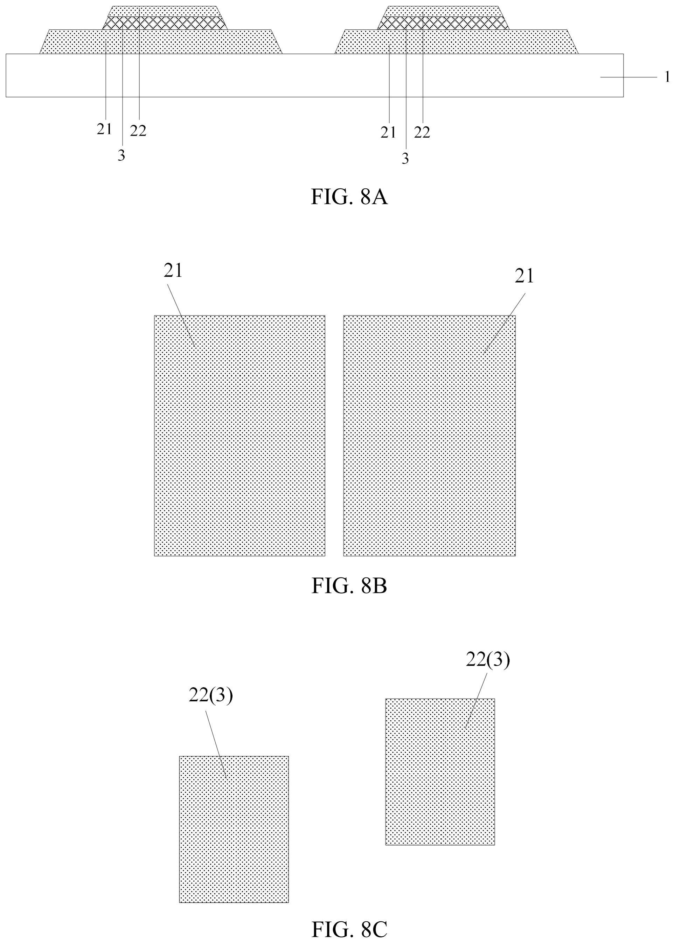

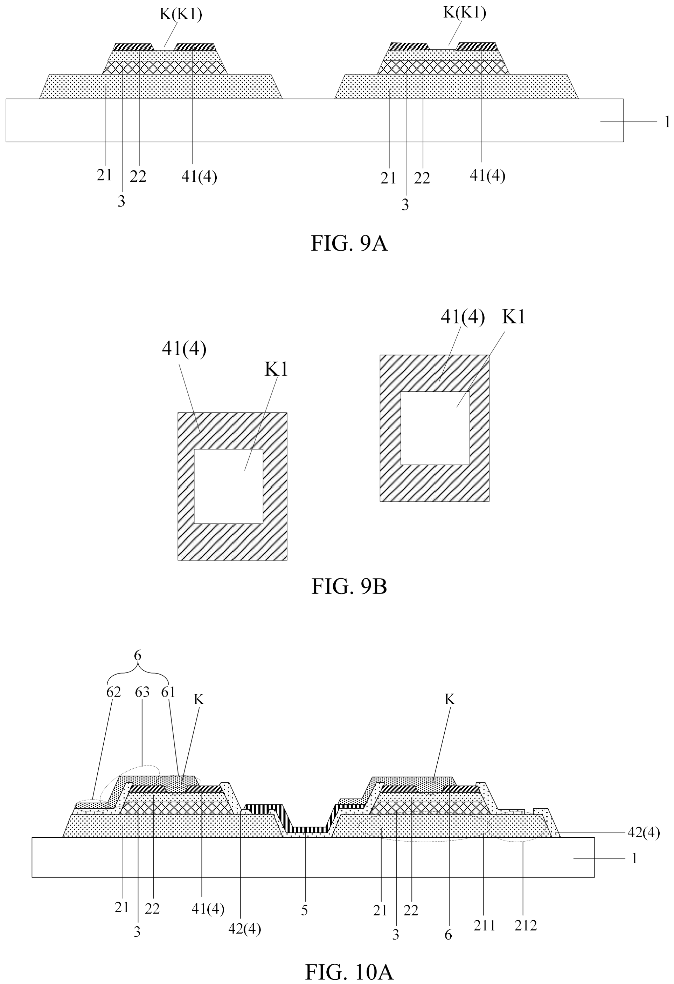

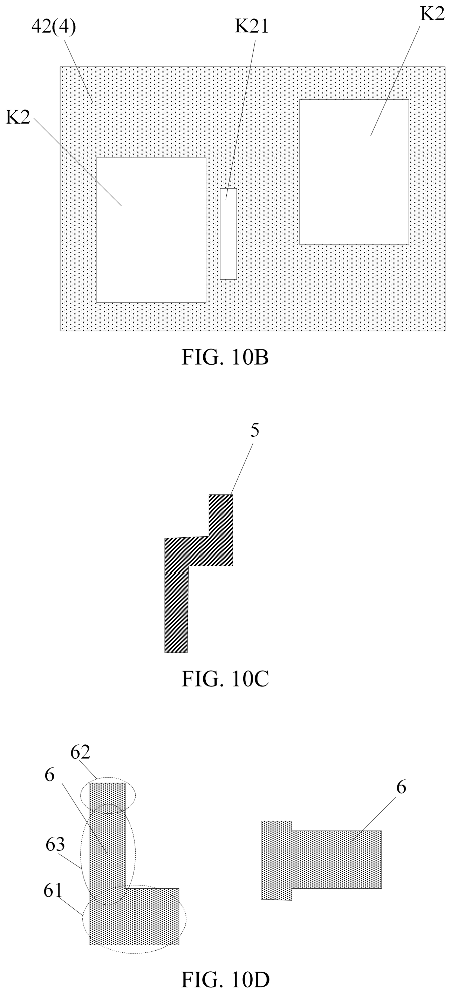

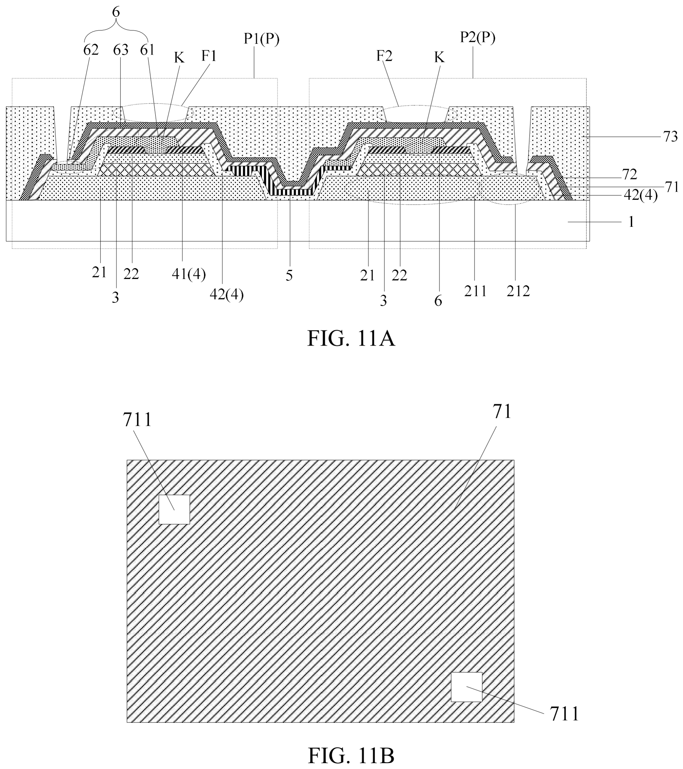

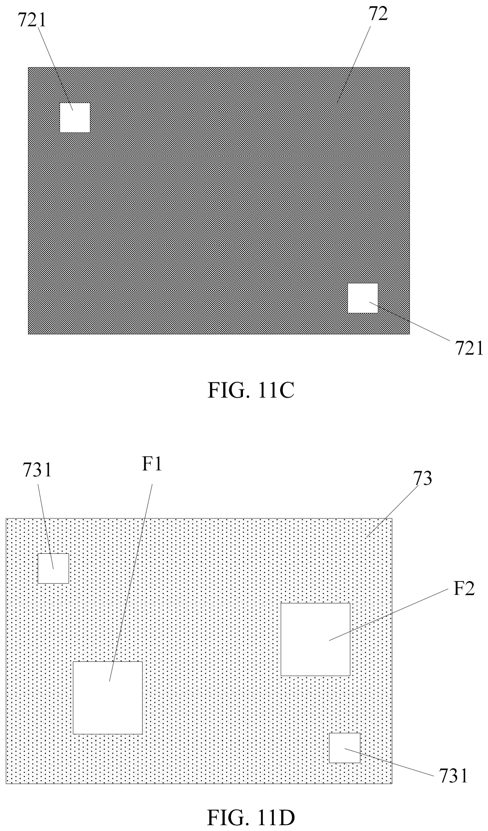

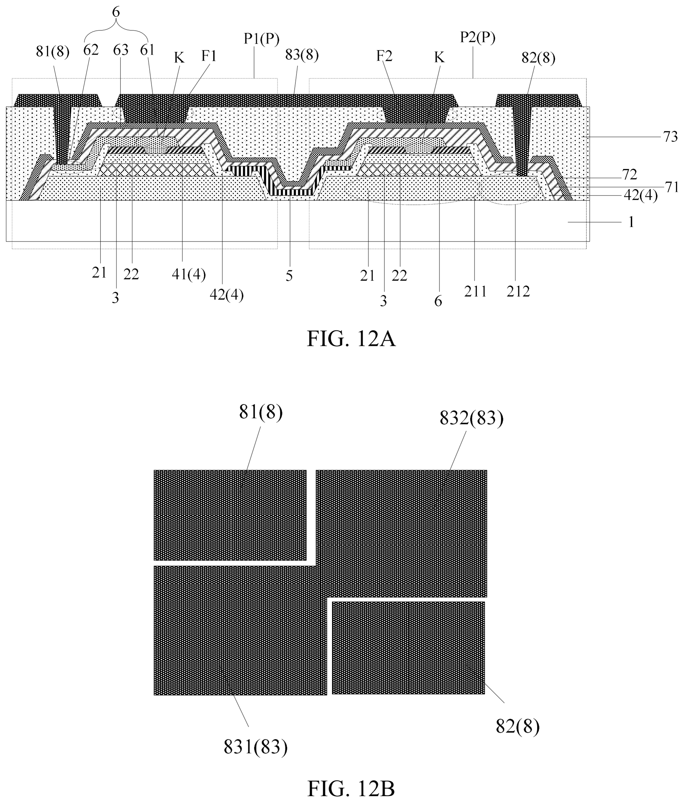

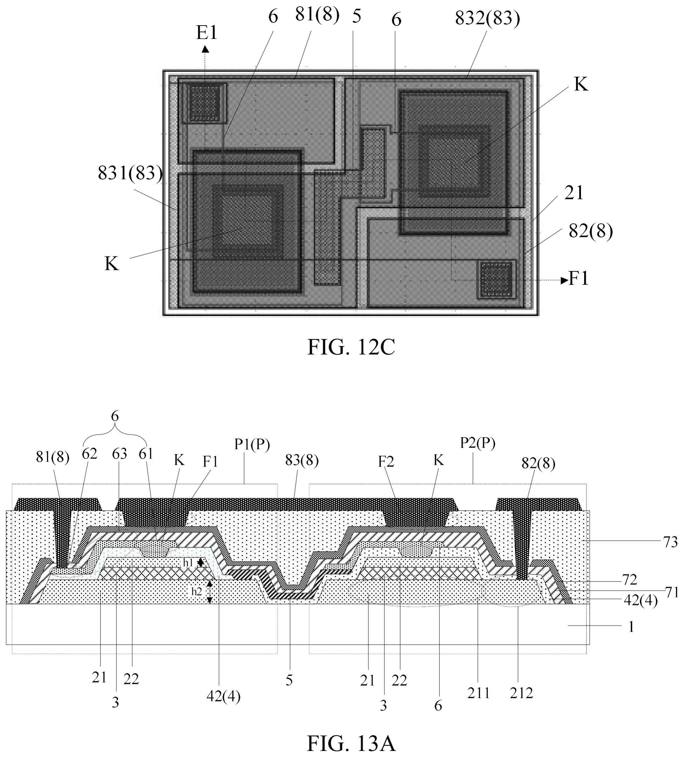

In one possible embodiment, taking the addition of the third semiconductor layer (a current blocker, CB) to reduce an effective light-emitting area, and the manufacture of a corresponding heat dissipation channel of a driving backplane as an example, a detailed explanation is given:
step 1: a base film layer of a light-emitting structure P is manufactured on a base substrate 1 (e.g., a sapphire substrate), a manufacturing method can be in particular a conventional manufacturing process for LED chips, which will not be described here, including the manufacture of three layers of n-GaN (as the first semiconductor layer 21), a quantum well (MQW, as the light-emitting layer 3), and p-GaN (as the second semiconductor layer 22), and as shown in Figs. 8A, 8B, and 8C, FIG. 8A is a schematic sectional view after forming the second semiconductor layer 22, FIG. 8B is a top view of a single film layer of the light-emitting layer 3, and FIG. 8C is a top view of a single film layer of the second semiconductor layer 22;
step 2, the third semiconductor layer 41 (an electron blocking layer) is manufactured, and an opening K defining a light-emitting region is formed, the electron blocking layer is made of n-doped GaN or other materials, during operation of the LED, the electron blocking layer and p-GaN form a reverse PN junction to block the flow of electrons, and the opening K of the electron blocking layer normally emits light, thereby defining the size of the light-emitting region, as shown in FIG. 9A and FIG. 9B, the opening K in FIG. 9B shows an effective light-emitting region of the LED, wherein FIG. 9A is a schematic sectional view after forming the third semiconductor layer 41, and FIG. 9B is a top view of a single film layer of the third semiconductor layer 41;
step 3, the passivation layer 42 is manufactured, and the bridge electrode 5, and the landing electrode 6 are manufactured, light-emitting structures P at two sides are connected, in this step, two sub-LEDs (light-emitting structures P) connected in series are manufactured inside the same LED (the light-emitting device), after all connections are completed, a n-electrode of the left sub-LED will be connected to a p-electrode of the right sub-LED, forming a high voltage LED (in an AMLED driving circuit, in a current path of VDD-VSS, the LED is equivalent to connecting two LEDs in series, and the LED has a higher crossover voltage, thus becoming the high voltage LED); the landing electrode 6 (made of a material which may specifically be indium tin oxide) is subjected to landing by the bridge electrode 5 to form a potential connection, the landing electrode 6 of the left sub-LED connected to the p electrode extends beyond the light-emitting region, so as to subsequently keep the p electrode away from the light-emitting region with respect to via holes 711 of the reflective layer 71 to avoid affecting the light emission of the LED, and as shown in Figs. 10A, 10B, 10C, and 10D, FIG. 10A is a schematic sectional view after forming the landing electrode 6, FIG. 10B is a top view of a single film layer of the passivation layer 42, FIG. 10C is a top view of a single film layer of the bridge electrode 5, and FIG. 10D is a top view of a single film layer of the landing electrode 6;
step 4, the reflective layer 71 is manufactured, about 50% of light emitted from the quantum well (the light-emitting layer 3) faces away from the side of the base substrate 1 (sapphire) when the LED is in operation, so the reflective layer 71, which may in particular be a distributed Bragg reflector (DBR), is required to reflect the light facing away from the base substrate 1 back to the sapphire side, improving the light emission of the LED, and a 1/4 wavelength reflector of desired light composed of superimposed SiO₂ and TiO₂ can be adopted; however, when a conventional LED is connected to the p electrode, it is necessary to land p-GaN in the light-emitting region through via holes formed after etching the DBR, metal of the p electrode absorbs part of photons to reduce the luminous efficiency, and in the embodiments of the present disclosure, after reducing the effective light-emitting region of the LED, the proportion of via holes increases, and the luminous efficiency of the LED is reduced instead, so there is a need of a certain method to move via holes of the p-electrode out of the light-emitting region and manufacture a relatively complete DBR to improve the light emission; the heat dissipation layer 72 (heat sink) is manufactured on an outer layer of the DBR, wrapping the entire LED and leaving via holes for subsequent Pad (a connection pad layer 8) connection electrodes; the LED is encapsulated through the encapsulation layer 73 and Pad metal vias are etched for subsequent connection of the heat dissipation channel and the electrode, and as shown in Figs. 11A, 11B, 11C, and 11D, FIG. 11A is a schematic sectional view after forming the encapsulation layer 73, FIG. 11B is a top view of a single film layer of the reflective layer 71, FIG. 11C is a top view of a single film layer of the heat dissipation layer 72, and FIG. 11D is a top view of a single film layer of the encapsulation layer 73; and
step 5, manufacture of the connection pad layer 8 is completed, the heat dissipation layer 72 directly facing the opening K is connected through the first encapsulation opening F1 and the second encapsulation opening F2 of the encapsulation layer 73 to form a heat dissipation channel, the corresponding electrodes are connected to form an electrical connection of the n and p electrodes of the LED, and as shown in FIG. 12A, FIG. 12B, and FIG. 12C, FIG. 12A is a schematic sectional view after forming the connection pad layer 8, FIG. 12B is a top view of a single film layer of the connection pad layer 8, and FIG. 12C is a top view of the overall light-emitting device, and FIG. 12A may be a schematic sectional view of FIG. 12C along a dashed line E1F1.

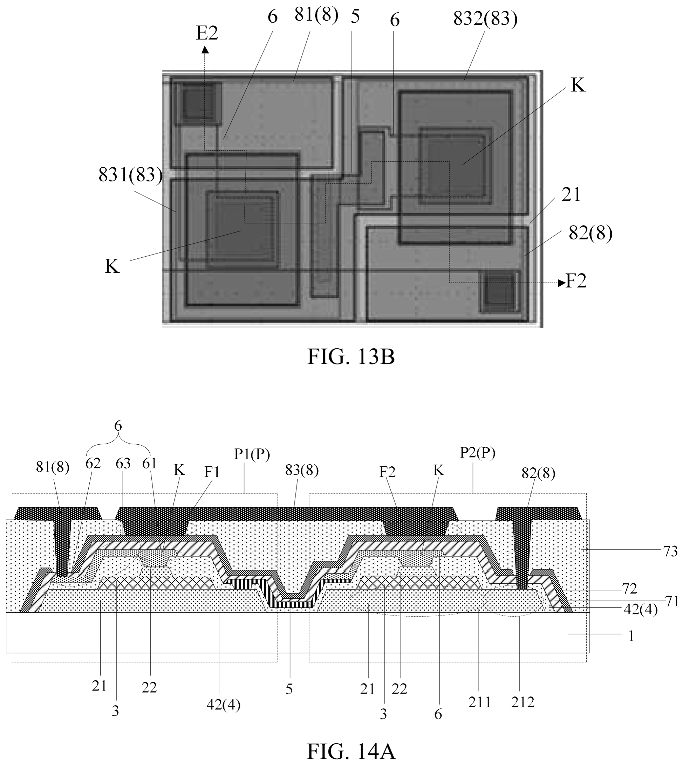

In another possible implementation, the size of the effective light-emitting region can be controlled by adjusting the size of the third sub-opening of the passivation layer 42, in this embodiment, the thickness of p-GaN can be reduced, excessive lateral diffusion of current in p-GaN is avoided, and the current enters the quantum well as soon as possible; a via area of the third sub-opening K3 of the passivation layer 42 is a landing area of the landing electrode 6 and p-GaN, i.e. the effective light-emitting region, wherein FIG. 13A is a schematic sectional view after forming the connection pad layer 8, FIG. 13B is a top view of the overall light-emitting device, and FIG. 13A can be a schematic sectional view of FIG. 13B along a dashed line E2F2; and a specific manufacture process for film layers may be similar to that in the above embodiment, which will not be repeated in the embodiments of the present disclosure.

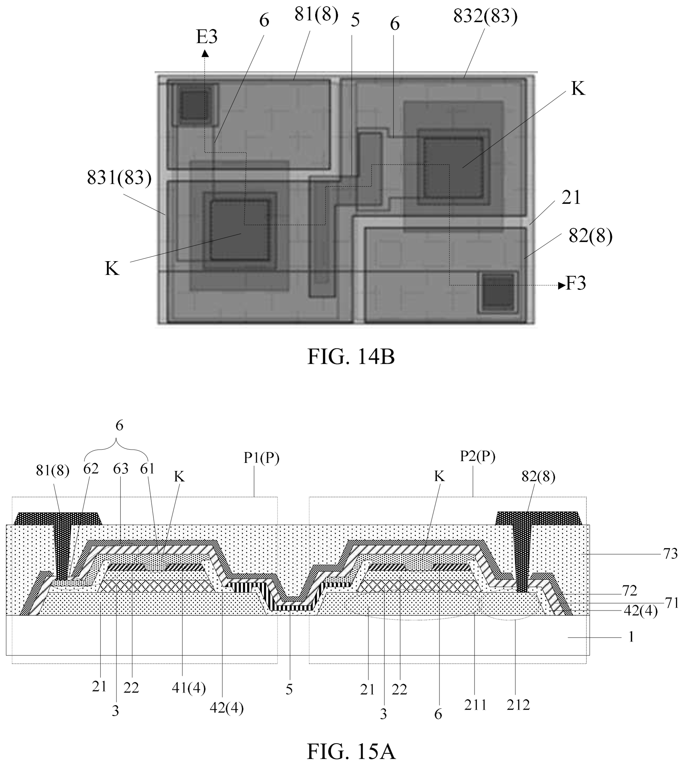

In another possible embodiment, the area of the second semiconductor layer 22 (p-GaN) is reduced by etching, limiting the effective light-emitting region; in specific implementation, a situation that the quantum well layer is etched, resulting in the formation of a structure aligned with p-GaN can be avoided, and a situation that if being aligned, a leakage channel is formed through a lattice structure where the edges of p-GaN, the quantum well, and n-GaN are damaged is avoided, thereby reducing the luminous efficiency of the LED, wherein FIG. 14A is a schematic sectional view after forming the connection pad layer 8, FIG. 14B is a top view of the overall light-emitting device, and FIG. 14A can be a schematic sectional view of FIG. 14B along a dashed line E3F3; and a specific manufacture process for film layers may be similar to that in the above embodiment, which will not be repeated in the embodiments of the present disclosure.

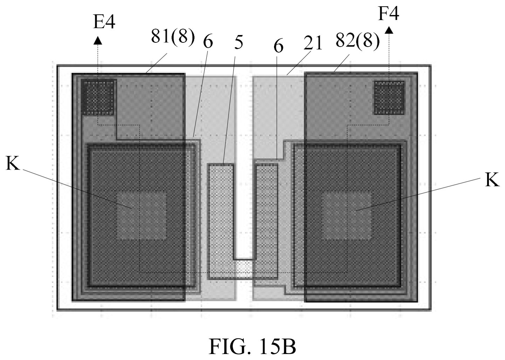

In another possible embodiment, the connection pad layer 8 may also not be provided with the heat dissipation pad 83, taking the addition of the third semiconductor layer (a current blocker, CB) to reduce an effective light-emitting area, and the manufacture of a corresponding heat dissipation channel of a driving backplane as an example, a structural schematic diagram of the manufactured light-emitting device is specifically shown in Figs. 15A, and 15B, wherein FIG. 15A is a schematic sectional view after forming the connection pad layer 8, and FIG. 15B is a top view of the overall light-emitting device, and FIG. 15A may be a schematic sectional view of FIG. 15B along a dashed line E4F4; and a specific manufacture process for film layers may be similar to that in the above embodiment, which will not be repeated in the embodiments of the present disclosure.

The beneficial effects of the embodiments of the present disclosure are as follows: in the embodiments of the present disclosure, the side, facing away from the light-emitting layer 3, of the second semiconductor layer 22 is provided with the barrier structure 4, the barrier structure 4 is provided with the opening K for exposing the second semiconductor layer 22, the orthographic projection of the opening K on the base substrate 1 is located in the orthographic projection of the light-emitting layer 3 on the base substrate 1, and the area of the opening K is smaller than that of the light-emitting layer 3, the landing electrode 6 is in contact with the second semiconductor layer 22 through the opening K, the opening K for exposing the second semiconductor layer 22 of the barrier structure 4 forms an effective light-emitting region, an area of the effective light-emitting region is smaller than that of the original light-emitting layer 3, so that a light-emitting region of the light-emitting device is reduced, the luminous efficiency of the light-emitting device can be improved under the condition that the applied gray scale voltage is the same, and the power consumption of the light-emitting device is reduced on the basis of maintaining the excellent display quality.

Although preferred embodiments of the present disclosure have been described, those skilled in the art can make additional changes and modifications to these embodiments once they know the basic inventive concepts. Therefore, the appended claims are intended to be explained as including the preferred embodiments and all changes and modifications falling within the scope of the present disclosure.

It will be apparent to those skilled in the art that various changes and modifications can be made to the embodiments of the present disclosure without departing from the scope of the embodiments of the present disclosure. Thus, if these changes and modifications of the embodiments of the present disclosure fall within the scope of the claims of the present disclosure, the present disclosure is also intended to include these changes and modifications. Further aspects of the invention include light-emitting devices and methods for manufacturing a light-emitting device according to the following clauses:
1. A light-emitting device, comprising: a base substrate, and at least one light-emitting structure on one side of the base substrate; wherein the light-emitting structure comprises:
   a first semiconductor layer;
   a light-emitting layer on a side, facing away from the base substrate, of the first semiconductor layer;
   a second semiconductor layer on a side, facing away from the first semiconductor layer, of the light-emitting layer, wherein doping ions of the second semiconductor layer and the first semiconductor layer are oppositely charged;
   a barrier structure on a side, facing away from the light-emitting layer, of the second semiconductor layer, wherein the barrier structure is provided with an opening for exposing the second semiconductor layer, an orthographic projection of the opening on the base substrate is in an orthographic projection of the light-emitting layer on the base substrate, and an area of the opening is smaller than an area of the light-emitting layer; and
   a landing electrode on a side, facing away from the second semiconductor layer, of the barrier structure, wherein the landing electrode is in contact with the second semiconductor layer through the opening.
2. The light-emitting device according to clause 1, wherein an orthographic projection of the second semiconductor layer on the base substrate and the orthographic projection of the light-emitting layer on the base substrate substantially coincide with each other;
   the barrier structure comprises a third semiconductor layer and a passivation layer on a side, facing away from the second semiconductor layer, of the third semiconductor layer, wherein doping ions of the third semiconductor layer and the second semiconductor layer are oppositely charged; and the third semiconductor layer is provided with a first sub-opening for exposing a part of the second semiconductor layer, and the passivation layer is provided with a second sub-opening for exposing the third semiconductor layer and the first sub-opening; and
   the landing electrode is in contact with the second semiconductor layer through the first sub-opening of the third semiconductor layer.
3. The light-emitting device according to clause 1, wherein an orthographic projection of the second semiconductor layer on the base substrate and the orthographic projection of the light-emitting layer on the base substrate substantially coincide with each other;
   the barrier structure comprises a passivation layer; wherein the passivation layer is provided with a third sub-opening for exposing a part of the second semiconductor layer; and
   the landing electrode is in contact with the second semiconductor layer through the third sub-opening of the passivation layer.
4. The light-emitting device according to clause 3, wherein a thickness of the second semiconductor layer is 2-4% of a thickness of the first semiconductor layer.
5. The light-emitting device according to clause 1, wherein an orthographic projection of the second semiconductor layer on the base substrate is in the orthographic projection of the light-emitting layer on the base substrate, and an area of the orthographic projection of the second semiconductor layer on the base substrate is smaller than an area of the orthographic projection of the light-emitting layer on the base substrate;
   the barrier structure comprises a passivation layer; wherein the passivation layer is provided with a fourth sub-opening for exposing at least part of the second semiconductor layer; and
   the landing electrode is in contact with the second semiconductor layer through the fourth sub-opening of the passivation layer.
6. The light-emitting device according to clause 5, wherein an orthographic projection of the fourth sub-opening on the base substrate and the orthographic projection of the second semiconductor layer on the base substrate substantially coincide with each other.
7. The light-emitting device according to clause 6, wherein an area of the second semiconductor layer is one fifth to four fifths of an area of the light-emitting layer.
8. The light-emitting device according to any one of clauses 1 to 7, wherein the light-emitting device comprises at least two of the light-emitting structures connected in series with each other; and
   the light-emitting device further comprises an encapsulation layer on a side, facing away from the barrier structure, of the landing electrode, and the at least two light-emitting structures connected in series with each other are integrally encapsulated by the encapsulation layer.
9. The light-emitting device according to clause 8, wherein the light-emitting device comprises a first light-emitting structure and a second light-emitting structure which are connected in series with each other; and
   the light-emitting device further comprises a bridge electrode between the barrier structure and the landing electrode; the first semiconductor layer of the first light-emitting structure and the landing electrode of the second light-emitting structure are electrically connected by the bridge electrode.
10. The light-emitting device according to clause 9, wherein the barrier structure at least comprises a passivation layer; and
   one end of the bridge electrode is electrically connected with the first semiconductor layer of the first light-emitting structure through a via hole penetrating the passivation layer, and the other end of the bridge electrode is in direct contact and electrically connected with the landing electrode of the second light-emitting structure.
11. The light-emitting device according to clause 10, further comprising a connection pad layer on a side, facing away from the second semiconductor layer, of the encapsulation layer, wherein the connection pad layer comprises a first connection electrode pad electrically connected with the landing electrode of the first light-emitting structure, and a second connection electrode pad electrically connected with the first semiconductor layer of the second light-emitting structure.
12. The light-emitting device according to clause 11, wherein the landing electrode of the first light-emitting structure comprises a first contact portion in contact with the second semiconductor layer, a first landing portion, and a first connection portion connecting the first contact portion and the first landing portion; wherein an orthographic projection of the first landing portion on the base substrate does not overlap with the orthographic projection of the light-emitting layer on the base substrate; the first connection electrode pad is electrically connected with the first landing portion through a via hole; and
   the first semiconductor layer of the second light-emitting structure is provided with an overlapping portion which overlaps with the light-emitting layer, and an extension portion extending from the overlapping portion, and the second connection electrode pad is electrically connected with the extension portion through a via hole.
13. The light-emitting device according to clause 11, further comprising a heat dissipation layer between the encapsulation layer and the landing electrode; wherein an orthographic projection of the heat dissipation layer on the base substrate at least covers an orthographic projection of the opening of the first light-emitting structure on the base substrate, and covers an orthographic projection of the opening of the second light-emitting structure on the base substrate.
14. The light-emitting device according to clause 13, wherein the connection pad layer further comprises a heat dissipation pad which is in a conducting relationship with the heat dissipation layer, and an orthographic projection of the heat dissipation pad on the base substrate at least covers the orthographic projection of the opening of the first light-emitting structure on the base substrate, and covers the orthographic projection of the opening of the second light-emitting structure on the base substrate.
15. The light-emitting device according to clause 14, wherein the encapsulation layer is provided with a first encapsulation opening and a second encapsulation opening; wherein an orthographic projection of the first encapsulation opening on the base substrate covers the orthographic projection of the opening of the first light-emitting structure on the base substrate, and an orthographic projection of the second encapsulation opening on the base substrate covers the orthographic projection of the opening of the second light-emitting structure on the base substrate; and
   the heat dissipation pad is in contact with the thermal dissipation layer through the first encapsulation opening and the second encapsulation opening.
16. The light-emitting device according to clause 14, wherein the heat dissipation pad comprises a first heat dissipation pad covering the opening of the first light-emitting structure, and a second heat dissipation pad covering the opening of the second light-emitting structure, wherein the first heat dissipation pad and the second heat dissipation pad are integrally connected; and
   a center of the first connection electrode pad, a center of the second connection electrode pad, a center of the first heat dissipation pad, and a center of the second heat dissipation pad enclose a rectangle; and the center of the first connection electrode pad and the center of the second connection electrode pad are respectively located at two vertices on one diagonal line of the rectangle, and the center of the first heat dissipation pad and the center of the second heat dissipation pad are respectively located at two vertices on the other diagonal line of the rectangle.
17. The light-emitting device according to clause 13, wherein a reflective layer is arranged between the heat dissipation layer and the landing electrode.
18. A light-emitting substrate, comprising a driving backplane and the light-emitting devices according to any one of clauses 1 to 17 disposed on one side of the driving backplane.
19. The light-emitting substrate according to clause 18, wherein the driving backplane comprises driving structures in one-to-one correspondence with the light-emitting devices, wherein each of the driving structures comprises a first electrode, a second electrode, and a heat dissipation electrode; wherein each first electrode is in bound connection with the corresponding first connection electrode pad, each second electrode is in bound connection with the corresponding second connection electrode pad, and each heat dissipation electrode is in bound connection with the corresponding heat dissipation pad.
20. The light-emitting substrate according to clause 19, wherein the driving backplane further comprises heat dissipation connection electrodes, wherein the heat dissipation electrodes of different driving structures are electrically connected to each other through the heat dissipation connection electrodes.
21. A method for manufacturing a light-emitting device, comprising:
   forming a first semiconductor layer on one side of a base substrate;
   forming a light-emitting layer on the side, facing away from the base substrate, of the first semiconductor layer;
   forming a second semiconductor layer on the side, facing away from the first semiconductor layer, of the light-emitting layer;
   forming a barrier structure provided with an opening for exposing the second semiconductor layer on the side, facing away from the light-emitting layer, of the second semiconductor layer, wherein an orthographic projection of the opening on the base substrate is located in an orthographic projection of the light-emitting layer on the base substrate, and an area of the opening is smaller than an area of the light-emitting layer; and
   forming a landing electrode on the side, facing away from the second semiconductor layer, of the barrier structure such that the landing electrode is in contact with the second semiconductor layer through the opening.
22. The manufacturing method according to clause 21, wherein the forming the barrier structure provided with the opening for exposing the second semiconductor layer on the side, facing away from the light-emitting layer, of the second semiconductor layer comprises:
   forming a third semiconductor layer on the side, facing away from the light-emitting layer, of the second semiconductor layer, wherein doping ions of the third semiconductor layer and the second semiconductor layer are oppositely charged;
   patterning the third semiconductor layer to form a first sub-opening for exposing a part of the second semiconductor layer; and
   forming a passivation layer provided with a second sub-opening on the side, facing away from the second semiconductor layer, of the third semiconductor layer, wherein the second sub-opening exposes the third semiconductor layer and the first sub-opening.
23. The manufacturing method according to clause 21, wherein the forming the barrier structure provided with the opening for exposing the second semiconductor layer on the side, facing away from the light-emitting layer, of the second semiconductor layer comprises:
   forming a passivation layer on the side, facing away from the light-emitting layer, of the second semiconductor layer; and
   patterning the passivation layer to form a third sub-opening for exposing a part of the second semiconductor layer such that the landing electrode is in contact with the second semiconductor layer through the third sub-opening.
24. The manufacturing method according to clause 21, wherein the forming the second semiconductor layer on the side, facing away from the first semiconductor layer, of the light-emitting layer comprises: forming a second semiconductor layer of which an orthographic projection on the base substrate is in the orthographic projection of the light-emitting layer on the base substrate on the side, facing away from the first semiconductor layer, of the light-emitting layer, and an area of the orthographic projection of the second semiconductor layer on the base substrate is smaller than an area of the orthographic projection of the light-emitting layer on the base substrate; and
   the forming the barrier structure provided with the opening for exposing the second semiconductor layer on the side, facing away from the light-emitting layer, of the second semiconductor layer comprises:
   forming a passivation layer on the side, facing away from the light-emitting layer, of the second semiconductor layer; and
   patterning the passivation layer to form a fourth sub-opening for exposing the second semiconductor layer such that the landing electrode is in contact with the second semiconductor layer through the fourth sub-opening, wherein an orthographic projection of the fourth sub-opening on the base substrate and the orthographic projection of the second semiconductor layer on the base substrate substantially coincide with each other.

## Claims

1. A light-emitting device, comprising: a base substrate (1), and at least one light-emitting structure (P) on one side of the base substrate (1); wherein the light-emitting structure (P) comprises:
a first semiconductor layer (21);
a light-emitting layer (3) on a side, facing away from the base substrate (1), of the first semiconductor layer (21);
a second semiconductor layer (22) on a side, facing away from the first semiconductor layer (21), of the light-emitting layer (3), wherein doping ions of the second semiconductor layer (22) and the first semiconductor layer (21) are oppositely charged;
a barrier structure (4) on a side, facing away from the light-emitting layer (3), of the second semiconductor layer (22), wherein the barrier structure (4) is provided with an opening (K) for exposing the second semiconductor layer (22), an orthographic projection of the opening (K) on the base substrate (1) is in an orthographic projection of the light-emitting layer (3) on the base substrate (1), and an area of the opening (K) is smaller than an area of the light-emitting layer (3); and
a landing electrode (6) on a side, facing away from the second semiconductor layer (22), of the barrier structure (4), wherein the landing electrode (6) is in contact with the second semiconductor layer (22) through the opening (K);
wherein the light-emitting device further comprises an encapsulation layer (73) on a side, facing away from the barrier structure (4), of the landing electrode (6);
wherein the light-emitting device comprises a first light-emitting structure (P1) and a second light-emitting structure (P2) which are connected in series with each other;
wherein the light-emitting device further comprising a connection pad layer (8) on a side, facing away from the second semiconductor layer (22), of the encapsulation layer (73), wherein the connection pad layer (8) comprises a first connection electrode pad (81) electrically connected with the landing electrode (6) of the first light-emitting structure (P1), and a second connection electrode pad (82) electrically connected with the first semiconductor layer (21) of the second light-emitting structure (P2).

2. The light-emitting device according to claim 1, wherein an orthographic projection of the second semiconductor layer (22) on the base substrate (1) and the orthographic projection of the light-emitting layer (3) on the base substrate (1) substantially coincide with each other;
the barrier structure (4) comprises a third semiconductor layer (41) and a passivation layer (42) on a side, facing away from the second semiconductor layer (22), of the third semiconductor layer (41), wherein doping ions of the third semiconductor layer (41) and the second semiconductor layer (42) are oppositely charged; and the third semiconductor layer (41) is provided with a first sub-opening (K1) for exposing a part of the second semiconductor layer (22), and the passivation layer (42) is provided with a second sub-opening (K2) for exposing the third semiconductor layer (41) and the first sub-opening (K1); and
the landing electrode (6) is in contact with the second semiconductor layer (22) through the first sub-opening (K1) of the third semiconductor layer (41).

3. The light-emitting device according to claim 1, wherein an orthographic projection of the second semiconductor layer (22) on the base substrate (1) and the orthographic projection of the light-emitting layer (3) on the base substrate (1) substantially coincide with each other;
the barrier structure (4) comprises a passivation layer (42); wherein the passivation layer (42) is provided with a third sub-opening K3) for exposing a part of the second semiconductor layer (22); and
the landing electrode (6) is in contact with the second semiconductor layer (22) through the third sub-opening (K3) of the passivation layer.

4. The light-emitting device according to claim 3, wherein a thickness of the second semiconductor layer (22) is 2-4% of a thickness of the first semiconductor layer (21).

5. The light-emitting device according to claim 1, wherein an orthographic projection of the second semiconductor layer on the base substrate is in the orthographic projection of the light-emitting layer on the base substrate, and an area of the orthographic projection of the second semiconductor layer on the base substrate is smaller than an area of the orthographic projection of the light-emitting layer on the base substrate;
the barrier structure comprises a passivation layer; wherein the passivation layer is provided with a fourth sub-opening for exposing at least part of the second semiconductor layer; and
the landing electrode is in contact with the second semiconductor layer through the fourth sub-opening of the passivation layer.

6. The light-emitting device according to claim 5, wherein an orthographic projection of the fourth sub-opening (K4) on the base substrate (1) and the orthographic projection of the second semiconductor layer (22) on the base substrate (1) substantially coincide with each other.

7. The light-emitting device according to claim 6, wherein an area of the second semiconductor layer (22) is one fifth to four fifths of an area of the light-emitting layer (3).

8. The light-emitting device according to any one of claims 1 to 7, wherein the first light-emitting structure (P1) and the second light-emitting structure (P2) are integrally encapsulated by the encapsulation layer (73); and
the light-emitting device further comprises a bridge electrode (5) between the barrier structure (4) and the landing electrode (6); the first semiconductor layer (21) of the first light-emitting structure (P1) and the landing electrode (6) of the second light-emitting structure (22) are electrically connected by the bridge electrode (5).

9. The light-emitting device according to claim 8, wherein the barrier structure (4) at least comprises a passivation layer (42); and
one end of the bridge electrode (5) is electrically connected with the first semiconductor layer (21) of the first light-emitting structure (P1) through a via hole penetrating the passivation layer (42), and the other end of the bridge electrode (5) is in direct contact and electrically connected with the landing electrode (6) of the second light-emitting structure (P2).

10. The light-emitting device according to claim 9, wherein the landing electrode (6) of the first light-emitting structure (P1) comprises a first contact portion (61) in contact with the second semiconductor layer (22), a first landing portion (62), and a first connection portion (63) connecting the first contact portion (61) and the first landing portion (62); wherein an orthographic projection of the first landing portion (62) on the base substrate (1) does not overlap with the orthographic projection of the light-emitting layer (3) on the base substrate (1); the first connection electrode pad (81) is electrically connected with the first landing portion (62) through a via hole; and
the first semiconductor layer (21) of the second light-emitting structure (P2) is provided with an overlapping portion which overlaps with the light-emitting layer (3), and an extension portion extending from the overlapping portion, and the second connection electrode pad (82) is electrically connected with the extension portion through a via hole.

11. The light-emitting device according to claim 9, further comprising a heat dissipation layer (72) between the encapsulation layer (73) and the landing electrode (6); wherein an orthographic projection of the heat dissipation layer (72) on the base substrate (1) at least covers an orthographic projection of the opening of the first light-emitting structure (P1) on the base substrate (1), and covers an orthographic projection of the opening of the second light-emitting structure (P2) on the base substrate;
wherein a reflective layer (71) is arranged between the heat dissipation layer (8) and the landing electrode (6).

12. The light-emitting device according to claim 11, wherein the connection pad layer (8) further comprises a heat dissipation pad (83) which is in a conducting relationship with the heat dissipation layer (72), and an orthographic projection of the heat dissipation pad (83) on the base substrate (1) at least covers the orthographic projection of the opening of the first light-emitting structure (P1) on the base substrate (1), and covers the orthographic projection of the opening of the second light-emitting structure (P2) on the base substrate (1).

13. The light-emitting device according to claim 12, wherein the encapsulation layer (73) is provided with a first encapsulation opening (F1) and a second encapsulation opening (F2); wherein an orthographic projection of the first encapsulation opening (F1) on the base substrate (1) covers the orthographic projection of the opening of the first light-emitting structure (P1) on the base substrate (1), and an orthographic projection of the second encapsulation opening (F2) on the base substrate (1) covers the orthographic projection of the opening of the second light-emitting structure (P2) on the base substrate (1); and
the heat dissipation pad (83) is in contact with the thermal dissipation layer (72) through the first encapsulation opening (F1) and the second encapsulation opening (F2).

14. The light-emitting device according to claim 12, wherein the heat dissipation pad (83) comprises a first heat dissipation pad (831) covering the opening of the first light-emitting structure (P1), and a second heat dissipation pad (832) covering the opening of the second light-emitting structure (P2), wherein the first heat dissipation pad (831) and the second heat dissipation pad (832) are integrally connected; and
a center (O1) of the first connection electrode pad (81), a center (O2) of the second connection electrode pad (82), a center (O3) of the first heat dissipation pad (831), and a center (O4) of the second heat dissipation pad (832) enclose a rectangle; and the center (O1) of the first connection electrode pad (81) and the center (O2) of the second connection electrode pad (82) are respectively located at two vertices on one diagonal line of the rectangle, and the center (O3) of the first heat dissipation pad (831) and the center (O4) of the second heat dissipation pad (832) are respectively located at two vertices on the other diagonal line of the rectangle.

15. A light-emitting substrate, comprising a driving backplane and the light-emitting devices according to any one of claims 1 to 14 disposed on one side of the driving backplane;
wherein the driving backplane comprises driving structures in one-to-one correspondence with the light-emitting devices, wherein each of the driving structures comprises a first electrode, a second electrode, and a heat dissipation electrode; wherein each first electrode is in bound connection with the corresponding first connection electrode pad, each second electrode is in bound connection with the corresponding second connection electrode pad, and each heat dissipation electrode is in bound connection with the corresponding heat dissipation pad;
wherein the driving backplane further comprises heat dissipation connection electrodes, wherein the heat dissipation electrodes of different driving structures are electrically connected to each other through the heat dissipation connection electrodes.
